# EUROPEAN PATENT SPECIFICATION

(11) **EP 2 506 600 B1**
(45) Date of publication and mention of the grant of the patent: **15.06.2016**
(21) Application number: 11002727.3
(22) Date of filing: 01.04.2011
(51) Int. Cl.: H01L 35/20, H04R 25/00

(54) **Power supply for a hearing aid or hearing assistance system**
Stromversorgung für ein Hörgerät oder Hörhilfesystem
Alimentation en courant pour appareil auditif ou système d'aide auditive

(43) Date of publication of application: 03.10.2012
(73) Proprietor: Appavu Mariappan, Niraimathi, 70182 Stuttgart (DE)
(72) Inventor: Appavu Mariappan, Niraimathi, 70182 Stuttgart (DE)
(74) Representative: Wolf, Pfiz & Gauss Patentanwälte

(56) References cited:
- EP-A1- 2 051 544
- WO-A1-2006/017226
- DE-B3-102005 032 291
- DE-C1- 19 827 898
- JP-A- H11 223 679
- JP-A- 2004 221 259
- KR-A- 20080 103 126
- ZIDE J ET AL: "High efficiency semimetal/semiconductor nanocomposite thermoelectric materials", JOURNAL OF APPLIED PHYSICS, AMERICAN INSTITUTE OF PHYSICS. NEW YORK, US, vol. 108, no. 12, 20 December 2010 (2010-12-20), pages 123702-123702, XP012142208, ISSN: 0021-8979, DOI: 10.1063/1.3514145

## Description

*The invention relates to a Power supply for* a *hearing aid or* a *hearing assistance system comprising a thermocouple arrangement for producing an electric voltage based on the heat of the human body, said thermocouple arrangement having a thermocouple or an array of thermocouples fused together, a reference head and two electric voltage ends, said thermocouple or said array of thermocouples being adapted to be implanted in* a *human body,* a *carrier for said thermocouple or said array of thermocouples said carrier having a first side and* a *second side, said reference head is adapted to face the atmospheric temperature, said second side of said carrier being coated with gold or platinum or a thermally conducting material, and said thermocouple or said array of thermocouples being situated on said first side of said carrier.*

*Furthermore, the invention relates to* a *hearing aid or a hearing assistance system which includes such a power supply. The invention also relates to a method to drive a hearing aid or a hearing assistance system based on the heat of the human body.*

Till today hearing aids are used to facilitate the patients to compensate their partial hearing problem where the hearing is impaired either in certain frequency range or in full frequency range the amplitude of the sound heard is below the normal hearing. Most of the hearing aid uses a external batteries and therefore the hearing aid is either externally fixed or partially internally fixed through operation.

### Standard Technique:

Till now the standard technique is a hearing assistance or hearing aid, which are mounted externally with an external battery and/or a hearing aid device mounted inside the ear of a patient but the battery is mounted behind ear, but still externally.

WO 2011031881 with disposable battery describes Canal Hearing device with disposable batteries, where the batteries can be replaced as *and when it is necessary.* These devices and method necessitate a hearing assistance or hearing aid which is partially or fully situated at the outside which is partially or fully visible.

Some of the patients due to various reasons needed to have their entire hearing or hearing aid operatively implanted inside the ear. As there is no possibility of a lifelong usage of the hearing aid without battery or non-availability of a battery less device,

KR200387227 (Y1) describes rechargeable batteries, but still uses an external energy.

WO2006/ 017226 A1 *describes* a *thermo electric power supply for generating power for use by at least one load source. This thermoelectric power source comprises an implantable thermoelectric unit having at least one thermoelectric device and at least one impedance matching device constructed and arranged to match an output impedance* of *the said thermoelectric device with an input impedance of said load device.*

DE198 27 898 C1 *discloses* a *method and* a *device for providing electrical energy for an active medical device that is partially or fully implantable.*

### Invention:

The invention describes a method which utilizes the body heat to produce a voltage that can be amplified to use alternative to the battery. Therefore it can be implanted mostly inside the outer ear and not necessarily seen outside.

The method consists of a thermocouple or an array of thermocouples like Au-PI or any other suitable thermocouple which is not affecting the health. The thermocouple or array of thermocouple is sputtered on one side of a very thin sapphire (Al2O3) plate or any thermally conductive and electrically insulating material, which acts as a very good thermal base. Whereas the other side of the Sapphire is coated with gold which is in direct contact with the human body, for e.g. inside Ear, thereby conducts the heat, the body temperature to the thermocouple via sapphire, with very less delay as well as very less heat losses.

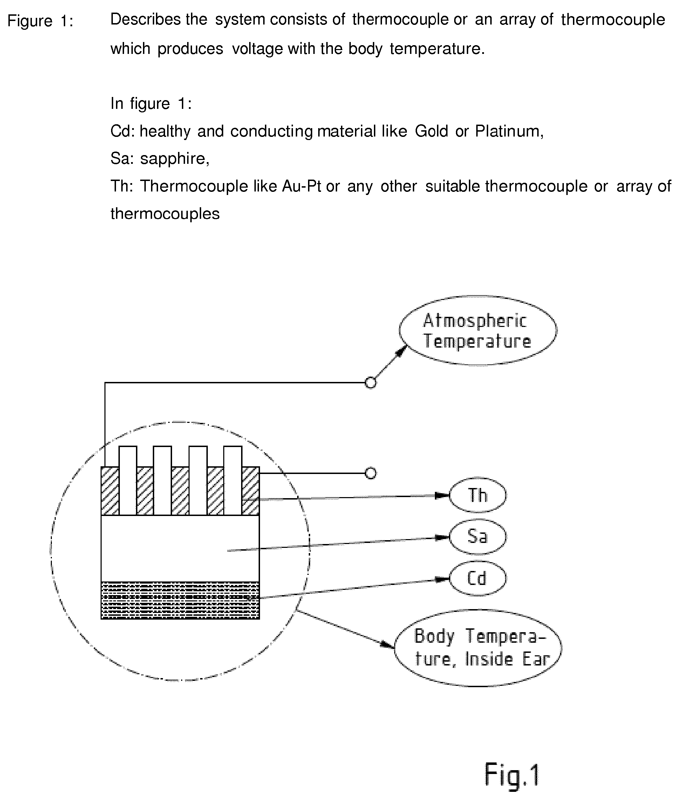

For the reference end of the thermocouple pt or Au or one of the thermocouple materials can be surrounded by Teflon, which is insulating polymer and amicable to skin and does not react with skin and is not disintegrate with time. The end of the thermocouple (Pt or Au) thus exposed to atmospheric temperature just outside the ear as shown in the figure 1.

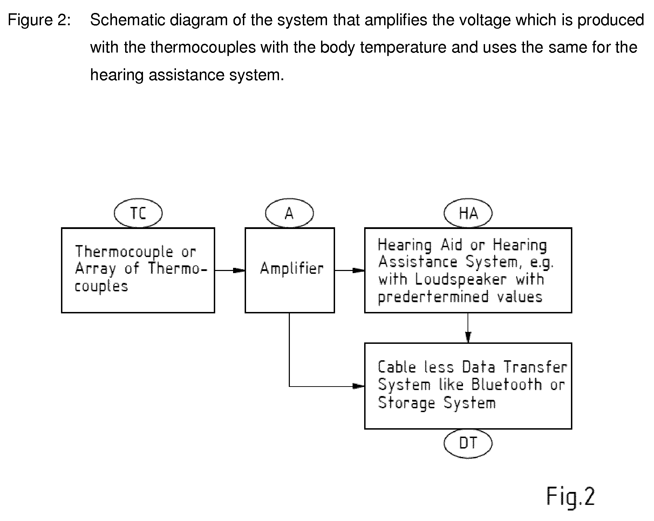

The Voltage ends are connected to the input of the amplifier that amplifies the mV thus developed at the ends of the thermocouple or array of thermocouples to Volts, necessary for driving the hearing aid or hearing assistance system. The entire can also be sputtered over the sapphire to avoid any unnecessary disturbing voltages or can also be separately incorporated in an ASIC system. The complete system is shown in Figure 2.

This method of utilizing body temperature to produce a self energy can be used to drive many implantable mechanisms or any other devices that can be implanted inside a human body which necessarily require a voltage or current or external power.
- Figure 1:: Describes the system consists of thermocouple or an array of thermocouple which produces voltage with the body temperature.
- Figure 2:: Schematic diagram of the system that amplifies the voltage which is produced with the thermocouples with the body temperature and uses the same for the hearing assistance system.

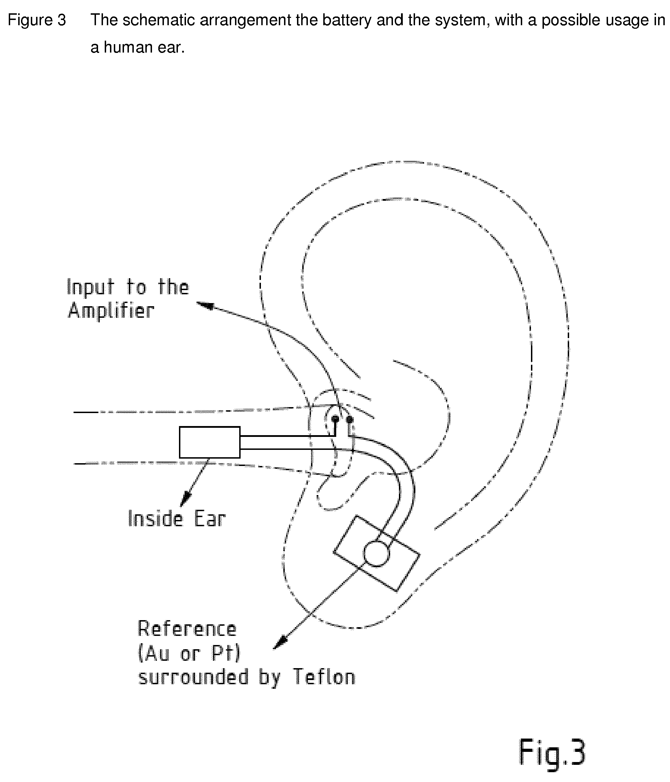

- Figure 3:: The schematic arrangement the battery and the system, with a possible usage in a human Ear.

*The invention describes a hearing aid which is driven with body heat as per claim 1. The parts of such a hearing aid which consists* of a *thermocouple or array of thermocouples, amplifier, and a loud speaker. The invention includes the possible data transformation from outside through* a *Bluetooth or any equivalent cable less data transfer system, that can be used to change or alter the loudspeaker, amplifiers data which enables a adjustability of the data necessary in the long run without a necessary operation on the patient.*

## Claims

1. Power supply for a hearing aid or a hearing assistance system comprising:
a thermocouple arrangement for producing an electric voltage based on the heat of the human body,
said thermocouple arrangement having:
a thermocouple or an array of thermocouples fused together,
a reference head, and
two electric voltage ends,
said thermocouple or said array of thermocouples being adapted to be implanted in a human body,
a carrier for said thermocouple or said array of thermocouples
said carrier having a first side and a second side,
said reference head is adapted to face the atmospheric temperature;
said second side of said carrier being coated with gold or platinum or a thermally conducting material;
**characterized by** that
said thermocouple or said array of thermocouples is situated on said first side of said carrier,
whereby
said carrier is made of thermally conductive and electrically insulating material.

2. Power supply as in claim 1, **characterized by** that said thermally conductive and electrically insulating material consists of sapphire.

3. Power supply as in claim 1 or 2, **characterized by** said reference head being surrounded by polytetrafluoroethylene (PTFE).

4. Hearing aid or a hearing assistance system having a power supply as claimed by one of the claims 1 to 3 and having an amplifier and a loudspeaker.

5. Hearing aid or a hearing assistance system having a power supply as claimed by claim 4, driven by a voltage of Volts (V) that is amplified from a voltage of milli Volts (mV) by said amplifier, said voltage of milli Volts (mV) being produced by said thermocouple or said array of thermocouples.

6. Hearing aid or a hearing assistance system of claim 5, **characterized by** said thermocouple or said array of thermocouples and said loudspeaker and said amplifier being integrated in one single ASIC.

7. Hearing aid or a hearing assistance system of claim 5 or 6, **characterized by** said loudspeaker having a loudspeaker output which is preadjustable to have a pre-desired value according to the needs of a patient.

8. Use of the Power supply of claim 1, claim 2 or claim 3 for powering cable less data transfer from outside through a Bluetooth system.

9. Method to drive a hearing aid or a hearing assistance system based on the heat of the human body comprising the steps of
providing a thermocouple arrangement for producing an electric voltage based on the heat of the human body,
said thermocouple arrangement having:
a thermocouple or an array of thermocouples fused together,
a reference head, and
two electric voltage ends,
said thermocouple or said array of thermocouples being adapted to be implanted in a human body,
a carrier for said thermocouple or said array of thermocouples,
said carrier having a first side and a second side,
providing thermal contact of said thermocouple or said array of thermocouples with the human body,
said reference head is adapted to face the atmospheric temperature;
said second side of said carrier being coated with gold or platinum or a thermally conducting material; whereby
**characterized by** that
said thermocouple or said array of thermocouples being situated on said first side of said carrier; and
said carrier is made of thermally conductive and electrically insulating material.

10. Method as in claim 9 **characterized by** that said carrier is made of thermally conductive and electrically insulating material consisting of sapphire.

## Patentansprüche

1. Elektrische Energieversorgung für ein Hörgerät oder ein Hörassistenzsystem umfassend:
eine Thermoelement-Anordnung für das Erzeugen einer elektrischen Spannung basierend auf der Wärme des menschlichen Körpers,
wobei die Thermoelement-Anordnung ein Thermoelement oder eine Anordnung von zusammengefügten Thermoelementen,
einen Referenzkopf und
zwei Anschluss-Enden für elektrische Spannung aufweist,
wobei das Thermoelement oder die Thermoelement-Anordnung für das Implantieren in einen menschlichen Körper ausgelegt ist,
einen Träger für das Thermoelement oder die Anordnung von Thermoelementen,
wobei der Träger eine erste Seite und eine zweite Seite aufweist,
wobei der Referenzkopf dazu ausgelegt ist, dass er der Atmosphärentemperatur ausgesetzt ist,
wobei die zweite Seite des Trägers mit Gold oder Platin oder einem wärmeleitenden Material beschichtet ist,
**dadurch gekennzeichnet, dass**
sich das Thermoelement oder die Anordnung von Thermoelementen auf der ersten Seite des Trägers befindet,
wobei der Träger aus einem wärmeleitenden und elektrisch isolierenden Material hergestellt ist.

2. Elektrische Energieversorgung nach Anspruch 1, **dadurch gekennzeichnet, dass** das wärmeleitende und elektrisch isolierende Material aus Saphir besteht.

3. Elektrische Energieversorgung nach Anspruch 1 oder 2, **dadurch gekennzeichnet, dass** der Referenzkopf mit Polytetrafluorethylen (PTFE) umgeben ist.

4. Hörgerät oder ein Hörassistenzsystem mit einer Stromversorgung nach einem der Ansprüche 1 bis 3 mit einem Verstärker und einen Lautsprecher.

5. Hörgerät oder ein Hörassistenzsystem mit einer Stromversorgung nach Anspruch 4, das mit einer im Volt-Bereich (V) liegenden Spannung betrieben wird, die durch Verstärken einer im milliVolt-Bereich (mV) liegenden mit dem Thermoelement oder der Anordnung von Thermoelementen erzeugten Spannung erhalten wird.

6. Hörgerät oder ein Hörassistenzsystem nach Anspruch 5, **dadurch gekennzeichnet, dass** das Thermoelement oder die Anordnung von Thermoelementen und der Lautsprecher und der Verstärker in einen einzigen ASIC integriert sind.

7. Hörgerät oder Hörassistenzsystem nach Anspruch 5 oder 6, **dadurch gekennzeichnet, dass** der Lautsprecher einen Lautsprecherausgang hat, der entsprechend den Bedürfnissen eines Patienten auf einen gewünschten Sollwert einstellbar ist.

8. Verwendung der Stromversorgung nach Anspruch 1, Anspruch 2 oder 3 für drahtlose Datenübertragung von außen mit einem Bluetooth-System.

9. Verfahren zum Versorgen eines Hörgeräts oder eines Hörassistenzsystem mit elektrischer Energie basierend auf der Wärme des menschlichen Körpers, umfassend die Schritte
Bereitstellen einer Thermoelement-Anordnung für das Erzeugen einer elektrischen Spannung,
wobei die Thermoelement-Anordnung ein Thermoelement oder eine Anordnung von zusammengefügten Thermoelementen,
einen Referenzkopf und
zwei Anschluss-Enden für elektrische Spannung aufweist,
wobei das Thermoelement oder die Thermoelement-Anordnung für das Implantieren in einen menschlichen Körper ausgelegt ist,
eines Trägers für das Thermoelement oder die Anordnung von Thermoelementen,
wobei der Träger eine erste Seite und eine zweite Seite aufweist, Herstellen von thermischem Kontakt des Thermoelements oder der Thermoelement-Anordnung mit dem menschlichen Körper,
wobei der Referenzkopf dazu ausgelegt ist, dass er der Atmosphärentemperatur ausgesetzt ist,
wobei die zweite Seite des Trägers mit Gold oder Platin oder einem wärmeleitenden Material beschichtet ist,
**dadurch gekennzeichnet, dass**
sich das Thermoelement oder die Anordnung von Thermoelementen auf der ersten Seite des Trägers befindet,
wobei der Träger aus einem wärmeleitenden und elektrisch isolierenden Material hergestellt ist und wobei der Referenzkopf von dem Träger getrennt angeordnet ist.

10. Verfahren nach Anspruch 9, **dadurch gekennzeichnet, dass** der Träger aus wärmeleitendem und elektrisch isolierendem Material bestehend aus Saphir hergestellt ist.

## Revendications

1. Source d'alimentation pour une audioprothèse ou un système d'aide auditive comprenant :
un agencement de thermocouple servant à générer une tension électrique à partir de la chaleur du corps humain,
ledit agencement de thermocouple ayant :
un thermocouple ou un réseau de thermocouples fusionnés ensemble,
une tête de référence, et
deux extrémités de tension électrique,
ledit thermocouple ou ledit réseau de thermocouples étant adapté pour être implanté dans un corps humain,
un support pour ledit thermocouple ou ledit réseau de thermocouples,
ledit support ayant un premier côté et un deuxième côté,
ladite tête de référence étant adaptée pour faire face à la température atmosphérique,
ledit deuxième côté dudit support étant recouvert d'or ou de platine ou d'un matériau thermoconducteur,
**caractérisée en ce que**
ledit thermocouple ou ledit réseau de thermocouples est situé sur ledit premier côté dudit support,
d'où il résulte que
ledit support est constitué d'un matériau thermoconducteur et électriquement isolant.

2. Source d'alimentation selon la revendication 1, **caractérisée en ce que** ledit matériau thermoconducteur et électriquement isolant consiste en du saphir.

3. Source d'alimentation selon la revendication 1 ou 2, **caractérisée en ce que** ladite tête de référence est entourée par du polytétrafluoroéthylène (PTFE).

4. Audioprothèse ou système d'aide auditive ayant une source d'alimentation selon une des revendications 1 à 3 et ayant un amplificateur et un haut-parleur.

5. Audioprothèse ou système d'aide auditive ayant une source d'alimentation selon la revendication 4, pilotés par une tension dans la gamme des volts (V) qui est amplifiée à partir d'une tension dans la gamme des millivolts (mV) par ledit amplificateur, ladite tension dans la gamme des millivolts (mV) étant générée par ledit thermocouple ou ledit réseau de thermocouples.

6. Audioprothèse ou système d'aide auditive selon la revendication 5, **caractérisés en ce que** ledit thermocouple ou ledit réseau de thermocouples et ledit haut-parleur et ledit amplificateur sont intégrés dans un seul ASIC.

7. Audioprothèse ou système d'aide auditive selon la revendication 5 ou 6, **caractérisés en ce que** ledit haut-parleur a une sortie de haut-parleur qui est préréglable pour avoir une valeur souhaitée au préalable correspondant aux besoins d'un patient.

8. Utilisation de la source d'alimentation selon la revendication 1, la revendication 2 ou la revendication 3 pour alimenter un transfert de données sans fil depuis l'extérieur par un système Bluetooth.

9. Procédé de pilotage d'une audioprothèse ou d'un système d'aide auditive à partir de la chaleur du corps humain comprenant les étapes consistant à
se procurer un agencement de thermocouple servant à générer une tension électrique à partir de la chaleur du corps humain,
ledit agencement de thermocouple ayant :
un thermocouple ou un réseau de thermocouples fusionnés ensemble,
une tête de référence, et
deux extrémités de tension électrique,
ledit thermocouple ou ledit réseau de thermocouples étant adapté pour être implanté dans un corps humain,
un support pour ledit thermocouple ou ledit réseau de thermocouples,
ledit support ayant un premier côté et un deuxième côté,
créer un contact thermique entre ledit thermocouple ou ledit réseau de thermocouples et le corps humain,
ladite tête de référence étant adaptée pour faire face à la température atmosphérique,
ledit deuxième côté dudit support étant recouvert d'or ou de platine ou d'un matériau thermoconducteur,
**caractérisé en ce que**
ledit thermocouple ou ledit réseau de thermocouples est situé sur ledit premier côté dudit support, et
ledit support est constitué d'un matériau thermoconducteur et électriquement isolant.

10. Procédé selon la revendication 9 **caractérisé en ce que** ledit support est constitué d'un matériau thermoconducteur et électriquement isolant consistant en du saphir.
